(19) Europäisches Patentamt
European Patent Office
Office européen des brevets

(11) **EP 1 395 844 B1**

## (12) EUROPÄISCHE PATENTSCHRIFT

(45) Veröffentlichungstag und Bekanntmachung des Hinweises auf die Patenterteilung:
**28.01.2009 Patentblatt 2009/05**

(21) Anmeldenummer: **02740625.5**

(22) Anmeldetag: **21.05.2002**

(51) Int Cl.:
**G01R 33/04** (2006.01)

(86) Internationale Anmeldenummer:
**PCT/EP2002/005559**

(87) Internationale Veröffentlichungsnummer:
**WO 2002/097463 (05.12.2002 Gazette 2002/49)**

(54) **MAGNETFELDSENSOR**

MAGNETIC FIELD SENSOR

CAPTEUR DE CHAMP MAGNETIQUE

(84) Benannte Vertragsstaaten:
**AT BE CH CY DE DK ES FI FR GB GR IE IT LI LU MC NL PT SE TR**

(30) Priorität: **25.05.2001 EP 01810518**

(43) Veröffentlichungstag der Anmeldung:
**10.03.2004 Patentblatt 2004/11**

(73) Patentinhaber: **Melexis Technologies SA 2022 Bevaix (CH)**

(72) Erfinder:
• **POPOVIC, Radivoje CH-1025 St-Sulpice (CH)**

• **RACZ, Robert CH-6300 Zug (CH)**
• **SCHOTT, Christian CH-1110 Morges (CH)**

(74) Vertreter: **Falk, Urs Patentanwaltsbüro Dr. Urs Falk Eichholzweg 9A 6312 Steinhausen (CH)**

(56) Entgegenhaltungen:
**EP-A- 0 359 922        EP-A- 0 893 699
EP-A- 1 052 519        WO-A-01/44826
DE-A- 4 102 928        FR-A- 2 802 650
GB-A- 2 340 251        US-A- 4 692 703
US-A- 5 199 178**

**EP 1 395 844 B1**

**Beschreibung**

Die Erfindung betrifft einen Magnetfeldsensor der im Oberbegriff des Anspruchs 1 genannten Art.

Solche Magnetfeldsensoren eignen sich für die Messung von Magnetfeldern, deren Stärke nur wenige nT bis mT beträgt, beispielsweise als Kompass zur Messung der Richtung des Magnetfeldes der Erde.

Ein Magnetfeldsensor der im Oberbegriff des Anspruchs 1 genannten Art ist aus der der EP 359 922 A1 bekannt. Bei diesem Magnetfeldsensor dient ein ringförmiger ferromagnetischer Kern zum Abschirmen bzw. Choppern des Magnetfelds, indem das zu messende Magnetfeld periodisch um den im Zentrum des ringförmigen Kerns angeordneten Magnetfeldsensor herum gelenkt wird.

Ein als Fluxgate betriebener Magnetfeldsensor ist aus der EP 1 052 519 A1 sowie aus dem Artikel "CMOS planar 2D micro-fluxgate sensor" der Autoren L. Chiesi, P. Kejik, B. Janossy und R.S. Popovic bekannt, der in der Zeitschrift Sensors and Actuators 82 (2000) 174 - 180 veröffentlicht wurde. Ein solcher Magnetfeldsensor enthält einen ferromagnetischen Kern und eine von einem Wechselstrom durchflossene Erregerspule, um den Kern im Wechsel magnetisch zu sättigen und zu entmagnetisieren. Ein gewichtiger Nachteil dieses Sensors liegt darin, dass eine ausreichende Empfindlichkeit mit einem relativ grossen ferromagnetischen Kern erkauft werden muss. Dies steht einer weitergehenden Miniaturisierung entgegen und macht den Sensor relativ teuer. Ein weiteres Problem besteht darin, dass der ferromagnetische Kern unbeabsichtigt durch ein äusseres Magnetfeld, welches sehr viel grösser ist als das eigentlich zu messende Feld, magnetisiert werden kann. Der in der Spule fliessende Strom schafft es dann nicht mehr, die einzelnen magnetischen Bezirke frei auszurichten, was zu einem Messfehler führt.

Ein weiterer als Fluxgate betriebener Magnetfeldsensor ist aus der US 4692703 bekannt. Bei diesem Magnetfeldsensor sind ein oder zwei horizontale Hallelemente in einem bzw. zwei Luftspalten eines ferromagnetischen Kerns angeordnet.

Die Erfindung besteht in den in den Ansprüchen 1 bzw. 5 angegebenen Merkmalen. Vorteilhafte Ausgestaltungen ergeben sich aus den abhängigen Ansprüchen.

Die Erfindung geht aus von einem Fluxgate Sensor aus, wie er z.B. aus dem obenerwähnten Artikel bekannt ist. Fluxgate Sensoren weisen eine Erregerspule, einen ferromagnetischen Kern und eine Auslesespule auf. Sie sind geeignet für die Messung schwacher Magnetfelder, da das zu messende Magnetfeld mit Hilfe der Erregerspule und des ferromagnetischen Kerns gechoppert wird, d.h. am Ort der Auslesepule periodisch ein- und ausgeschaltet wird. Das Ausgangssignal der Auslesepule lässt sich dann mit der Lock-In Technik synchron zur Chopperung auswerten. Die Erfindung schlägt vor, für die Optimierung der Eigenschaften eines für die Messung schwacher Magnetfelder vorgesehenen Magnetfeldsensors alle in der Halbleitertechnologie gebräuchlichen Prozesse einzubeziehen, d.h. alle Prozesse vom Beginn der Herstellung der Halbleiterchips auf einem Wafer über das Postprocessing, wo der ferromagnetische Kern aufgebracht wird, bis zum Backend, wo der Halbleiterchip montiert und zum fertigen Magnetfeldsensor verkapselt wird. Dieser Ansatz ermöglicht die Verwendung eines ringförmigen ferromagnetischen Kerns, dessen Vorteil darin liegt, dass er sich mit einem Mimimum an elektrischem Strom und an elektrischer Leistung magnetisch in Sättigung bringen lässt. Die Windungen der Erregerspule bestehen dann vorteilhafterweise aus Leiterbahnen und Bonddrähten. Zudem schlägt die Erfindung vor, anstelle der Auslesespulen Hallelemente zu verwenden, da deren Grösse ohne Verlust an Empfindlichkeit beliebig verkleinert werden kann. Ein solcher Magnetfeldsensor lässt sich sehr stark miniaturisieren.

Nachfolgend werden Ausführungsbeispiele der Erfindung anhand der Zeichnung näher erläutert.

Es zeigen:

Fig. 1    einen Magnetfeldsensor mit einer Erregerspule und einem ferromagnetischen Kern zum Choppern des Messfeldes,
Fig. 2A, B    Feldlinien eines Magnetfeldes,
Fig. 3    einen Magnetfeldsensor mit einer Erregerspule mit mehreren Windungen,
Fig. 4    einen als Flipchip montierten Magnetfeldsensor,
Fig. 5    einen weiteren Magnetfeldsensor,
Fig. 6    einen Magnetfeldsensor mit einer als Flachspule ausgebildeten Erregerspule,
Fig. 7    Details einer weiteren Erregerspule, und
Fig. 8    einen Fluxgate Sensor.

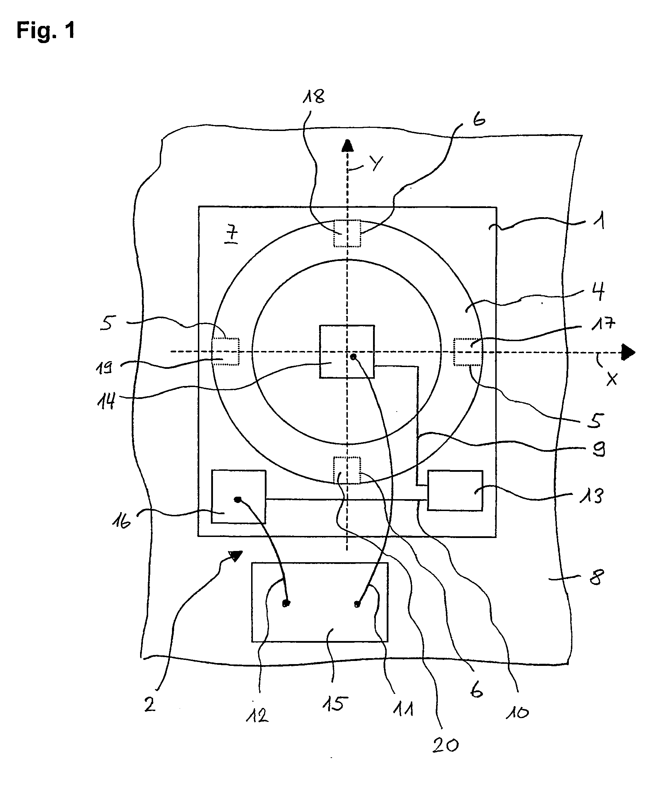

Die Fig. 1 zeigt in Aufsicht einen als Halbleiterchip 1 ausgebildeten Magnetfeldsensor für die Messung von zwei Komponenten eines Magnetfeldes. Als Bezugssystem dient ein kartesisches x,y,z Koordinatensystem, wobei die z-Richtung senkrecht zur Zeichenebene verläuft. Der Magnetfeldsensor umfasst eine mit einem Strom beaufschlagbare Erregerspule 2 mit mindestens einer Windung, einen ringförmigen ferromagnetischen Kern 4, zwei Auslesesensoren 5, 6 und eine elektronische Schaltung 7. Der Auslesesensor 5 dient der Erfassung der x-Komponente des Magnetfeldes, der Auslesesensor 6 dient der Erfassung der y-Komponente des Magnetfeldes. Vorzugsweise bestehen die Auslesesensoren 5, 6 je aus zwei örtlich getrennten, aber elektrisch verbundenen Sensoren. Der Magnetfeldsensor ist in einer Technologie hergestellt, bei der zunächst die elektronische Schaltung 7, Teile der Erregerspule 2 und die Auslesesensoren 5, 6 in einer Standard CMOS Technologie gefertigt und anschliessend der ferromagnetische Kern 4 in einem sogenannten Post-Prozess aufgebracht wurde. Dabei wird ein Band aus amorphem ferromagnetischem Material auf den Wafer mit den Halbleiterschaltungen aufgeklebt und mittels Photolithografie und chemischem Ätzen strukturiert. Nach dem Zersägen des Wafers in die einzelnen Halbleiterchips wird die mindestens eine Windung der Erregerspule 2 bei der Montage des Halbleiterchips auf ein Substrat 8 entweder durch Drahtbonden oder mittels der Flipchip Technologie vervollständigt. Die elektronische Schaltung 7 dient der Erzeugung des die Erregerspule 2 durchfliessenden Stromes und der Auswertung der von den Auslesesensoren 5, 6 gelieferten Signale.

Bei dem in der Fig. 1 gezeigten Ausführungsbeispiel weist die Erregerspule 2 eine einzige Windung auf, die teilweise aus einer ersten Leiterbahn 9 und einer zweiten Leiterbahn 10 und teilweise aus zwei Bonddrähten 11 und 12 besteht. Die erste Leiterbahn 9 führt von einer ausserhalb des ringförmigen ferromagnetischen Kerns 4 angeordneten Stromquelle 13 unter dem ferromagnetischen Kern 4 hindurch zu einem innerhalb des ringförmigen ferromagnetischen Kerns 4 angeordneten ersten Bondpad 14. Der erste Bonddraht 11 führt vom ersten Bondpad 14 zu einem Bondpad 15 auf dem Substrat 8. Der zweite Bonddraht 12 führt von diesem Bondpad 15 zu einem zweiten, ausserhalb des ringförmigen ferromagnetischen Kerns 4 auf dem Halbleiterchip 1 angeordneten Bondpad 16. Die zweite Leiterbahn 10 führt vom zweiten Bondpad 16 zur Stromquelle 13.

Als Material für den ferromagnetischen Kern 4 dient beispielsweise das unter der Bezeichnung VAC 6025Z erhältliche Band aus amorphem Metall. Dieses Material hat eine Koerzitivfeldstärke $H_C$ = 3 mA/cm. Um den ferromagnetischen Kern 4 magnetisch in Sättigung zu bringen, sollte der durch die Erregerspule 2 fliessende Strom I ein Magnetfeld $H_S$ erzeugen, das etwa 20 mal grösser als die Koerzitivfeldstärke $H_C$ ist. Wenn der äussere Durchmesser D des ringförmigen ferromagnetischen Kerns 4 D = 300 $\mu$m und die Zahl n der Windungen der Erregerspule 2 n = 1 beträgt, dann erhält man für den Strom gemäss der Gleichung

$$I = 20*H_C*D*\pi/n \qquad\qquad\qquad (1)$$

I $\cong$ 6 mA. Der Duty Cycle des Stroms I kann zudem auf etwa 10% reduziert werden, wodurch sich der mittlere Strombedarf auf 0.6 mA reduziert. Da der ferromagnetische Kern 4 keinen Luftspalt hat, lässt er sich bereits durch ein kleines Magnetfeld und somit durch einen geringen Strom I magnetisch sättigen.

Der Magnetfeldsensor weist als Auslesesensoren 5 und 6 vier elektrisch paarweise gekoppelte, sogenannte horizontale Hallelemente 17, 18, 19 und 20 auf, die auf ein Magnetfeld empfindlich sind, das senkrecht zur Oberfläche des Halbleiterchips 1, d.h. in z-Richtung verläuft. Die Hallelemente 17 und 19 sind auf der x-Achse des kartesischen Koordinatensystems angeordnet und bilden den ersten Auslesesensor 5, die Hallelemente 18 und 20 sind auf der y-Achse des kartesischen Koordinatensystems angeordnet und bilden den zweiten Auslesesensor 6. Die Hallelemente 17 bis 20 sind jeweils unterhalb des ferromagnetischen Kerns 4 angeordnet und zwar in der Nähe des äusseren Randes des ferromagnetischen Kerns 4.

Im Betrieb arbeitet der Magnetfeldsensor wie folgt: Die Erregerspule 2 wird von der Stromquelle 13 mit einem vorzugsweise rechteckförmigen Wechselstrom beaufschlagt. Der Wechselstrom sättigt und entmagnetisiert dabei den ferromagnetischen Kern 4 mit der Frequenz des Wechselstromes. In der Phase, wo der ferromagnetische Kern 4 magnetisch gesättigt ist, übt er auf das zu messende, externe Magnetfeld keine Wirkung aus. Die Feldlinien des Magnetfeldes verlaufen parallel zur Oberfläche der Hallelemente 17 bis 20: Die Hallelemente liefern kein Ausgangssignal. In der Phase, wo der ferromagnetische Kern 4 entmagnetisiert ist, wirkt er auf das zu messende Magnetfeld als magnetischer Flusskonzentrator. Da die relative Permeabilität $\mu_r$ des ferromagnetischen Kerns 4 sehr gross gegenüber der relativen Permeabilität seiner Umgebung ist, treffen die Feldlinien des Magnetfeldes annähernd senkrecht auf die Oberfläche des ferromagnetischen Kerns 4 auf bzw. verlassen diesen unter fast senkrechtem Winkel. Die Feldkonzentration ist am grössten im Bereich des Randes des ferromagnetischen Kerns 4, wo sich die Hallelemente 17 bis 20 befinden. Die Ausgangssignale von mindestens zwei der vier Hallelemente 17 bis 20 sind dann verschieden von Null.

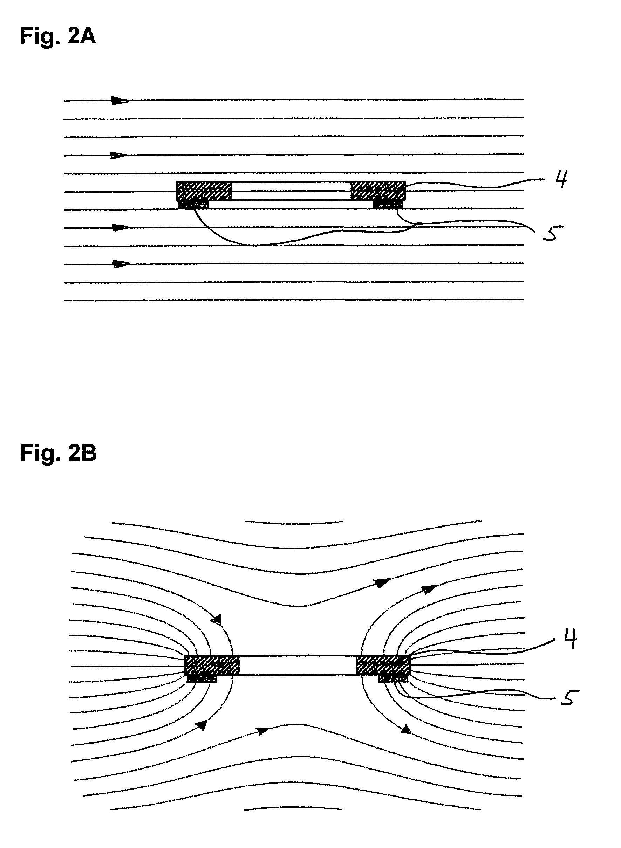

Die Fig. 2A zeigt die Feldlinien 21 des Magnetfeldes, wenn der ferromagnetische Kern 4 gesättigt ist und wenn das Magnetfeld entlang der x-Richtung und somit parallel zur Oberfläche des Halbleiterchips 1 verläuft. Dargestellt sind nur der ferromagnetische Kern 4 und zwei Sensoren des Auslesesensors 5. Die Schnittebene der Figur verläuft senkrecht zur Oberfläche des Halbleiterchips 1 und parallel zum äusseren Magnetfeld. Die Fig. 2B zeigt die Feldlinien 22 desselben Magnetfeldes, wenn der ferromagnetische Kern 4 durch das von dem durch die Erregerspule fliessenden Strom nicht gesättigt ist. Die Feldlinien am Ort der beiden Sensoren des Auslesesensors 5 zeigen in unterschiedliche z-Richtung, da das Magnetfeld am Ort des einen Sensors des Auslesesensors 5 (in der Fig. 2B beispielsweise der linke Sensor des Auslesesensors 5) in den ferromagnetischen Kern 4 eintritt und am Ort des anderen Sensors des Auslesesensors 5 (in der Fig. 2B der rechte Sensor des Auslesesensors 5) diesen wieder verlässt. Die beiden Sensoren des Auslesesensors 5 sind elektrisch entsprechend geschaltet.

Die Erregerspule 2 dient also dazu, den ferromagnetischen Kern zur Chopperung des zu messenden Magnetfeldes zu benützen. Die Ausgangssignale der Hallelemente 17 bis 20 können dann mittels der bekannten Lock-In Technik synchron mit dem durch die Erregerspule 2 fliessenden Strom ausgewertet werden.

Im folgenden werden nun weitere Massnahmen beschrieben, deren Anwendung zu einer höheren Empfindlichkeit des Magnetfeldsensors und/oder zu einem geringeren Strom- bzw. Energieverbrauch führt.

Wenn die Zahl der Windungen der Erregerspule 2 auf n erhöht wird, dann kann bei gleichem Stromverbrauch entweder der durch die Erregerspule 2 fliessende Strom um den Faktor n verkleinert oder der Durchmesser D des ringförmigen ferromagnetischen Kerns 4 um den Faktor n vergrössert werden. Eine Vergrösserung des Durchmessers D bewirkt eine Verstärkung der Flusskonzentration, erhöht aber auch den Platzbedarf und damit die Abmessungen des Halbleiterchips 1. Im Hinblick auf das Ziel einer möglichst grossen Miniaturisierung des Magnetfeldsensors resultieren dann optimale Verhältnisse, wenn der Durchmesser D des ferromagnetischen Kerns 4 den Abmessungen des Halbleiterchips 1 angepasst wird, wie sie sich aus dem Platzbedarf für die elektronische Schaltung 7 ergeben, und die Zahl n der Windungen 3 der Grösse des ferromagnetischen Kerns 4 angepasst wird.

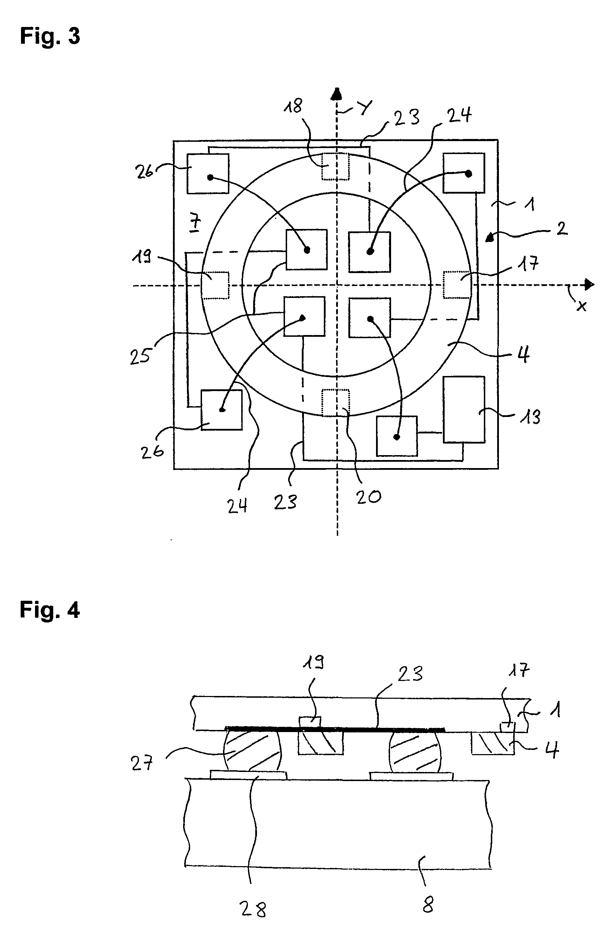

Die Fig. 3 zeigt in Aufsicht einen Magnetfeldsensor, dessen Erregerspule 2 vier in Reihe geschaltete Windungen aufweist. Die Windungen bestehen je aus einer Leiterbahn 23 und einem Bonddraht 24, wobei jeder Bonddraht 24 von einem Bondpad 25 innerhalb des ferromagnetischen Kerns 4 zu einem Bondpad 26 ausserhalb des ferromagnetischen Kerns 4 führt. Bei diesem Beispiel befinden sich alle Bondpads auf dem Halbleiterchip 1.

Die Fig. 4 zeigt im Schnitt einen als Flipchip montierten Magnetfeldsensor, bei dem die Windungen der Erregerspule mittels Leiterbahnen 23 auf dem Halbleiterchip 1, sogenannten Bumps 27 und Leiterbahnen 28 auf dem Substrat 8 realisiert sind.

Mit den beschriebenen Magnetfeldsensoren kann auch die z-Komponente des Magnetfeldes gemessen werden. Anders als bei einem parallel zur Oberfläche des Halbleiterchips 1 verlaufenden Magnetfeld zeigen hier die Feldlinien des Magnetfeldes bei allen Auslesesensoren 5, 6 bzw. Hallelementen 17 bis 20 in die gleiche Richtung. Die Hallelemente 17 bis 20 sind dann diesem Umstand entsprechend zu beschalten. Für die Messung der horizontal zur Oberfläche des Halbleiterchips 1 verlaufenden Komponenten des Magnetfeldes, d.h. der x- und der y-Komponente, muss die Differenz der Ausgangsspannungen der beiden Hallelemente 17 und 19 bzw. der beiden Hallelemente 18 und 20 ermittelt werden, während für die Messung der senkrecht zur Oberfläche des Halbleiterchips 1 verlaufenden z-Komponente die Summe der Ausgangsspannungen der Hallelemente 17 bis 20 ermittelt werden muss.

Solange die Dicke des ferromagnetischen Kerns 4, d.h. seine Ausdehnung in z-Richtung, vergleichsweise klein gegenüber seiner Breite ist, wirkt der ferromagnetische Kern 4 für die z-Komponente des Magnetfeldes nicht als Flusskonzentrator. Wenn die Dicke jedoch vergleichbar zu seiner Breite wird, dann wirkt der ferromagnetische Kern 4 auch als Flusskonzentrator für die z-Komponente des Magnetfeldes. Dann lässt sich das Magnetfeld mittels dem durch die Erregerspule fliessenden Strom auch bei der Messung der z-Komponente choppern, was die Empfindlichkeit des Magnetfeldsensors für die z-Komponente markant erhöht. Die Dicke des ferromagnetischen Kerns 4 beträgt dann bevorzugt mindestens das 0,5-flache seiner Breite.

Der durch die Erregerspule 2 fliessende Strom kann auch zur Speisung der Hallelemente 17 bis 20 verwendet werden, da der ohmsche Widerstand der Erregerspule 2 klein ist.

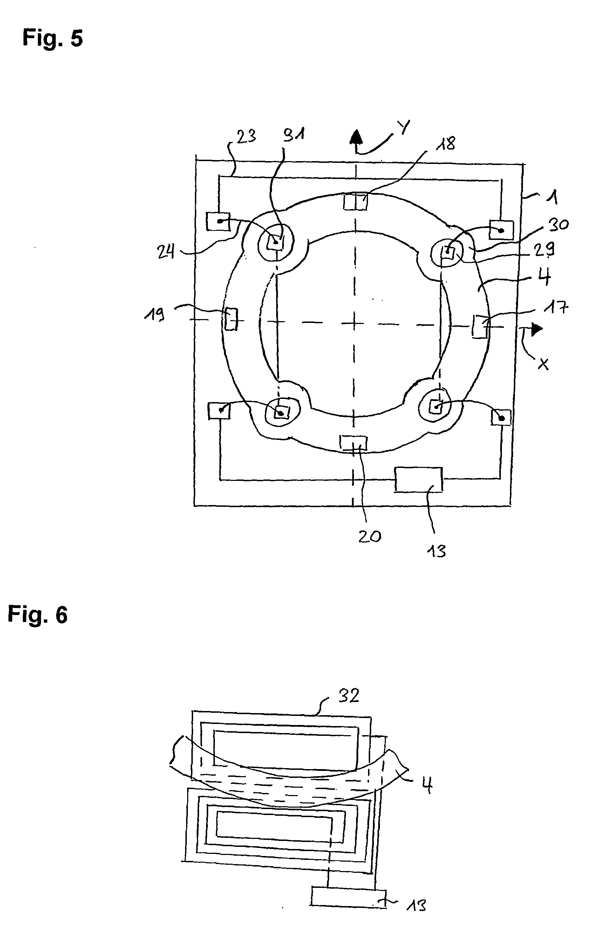

Eine weitere Massnahme zur Erhöhung der Effizienz des Magnetfeldsensors besteht darin, den ferromagnetischen Kern 4 derart auszugestalten, dass der ferromagnetische Kern 4 lokal magnetisch gesättigt werden kann, ohne dass der ganze ferromagnetische Kern 4 magnetisch gesättigt wird. Das Magnetfeld wird dann im Bereich der Auslesesensoren 5, 6, d.h. der Hallelemente 17 bis 20, immer noch ausreichend gechoppert. Die Fig. 5 zeigt in der Aufsicht einen derart modifizerten Magnetfeldsensor. Der ringförmige ferromagnetische Kern 4 mit dem Durchmesser D beinhaltet vier Löcher 29, so dass vier kleine Ringe 30 entstehen, die je zwischen zwei der Hallelemente 17 bis 20 angeordnet sind. Beispielsweise weisen der grosse Ring einen Durchmesser D = 1.5 mm und die kleinen Ringe 30 einen Durchmesser $d = 150\ \mu$m auf. Innerhalb jedes der kleinen Ringe 30 befindet sich ein Bondpad 31. Ein solcher kleiner Ring 30 stellt einen geschlossenen Magnetkreis dar. Die Erregerspule besteht wiederum aus Leiterbahnen 23 und Bonddrähten 24, die so ausgelegt und verdrahtet sind, dass der durch die Erregerspule fliessende Strom die kleinen Ringe 30 in Sättigung bringt. Der durch die Erregerspule fliessende Strom erzeugt in jedem der kleinen Ringe 30 ein Magnetfeld, das den kleinen Ring 30 magnetisch in Sättigung bringt. Unabhängig vom Durchmesser D des grossen Rings genügt bei Verwendung des Metallbandes VAC 6025Z ein gemäss Gleichung (1) berechneter Strom $I \cong 3$ mA zur magnetischen Sättigung der kleinen Ringe 30. Wenn die kleinen Ringe 30 gesättigt sind, dann verliert der grosse Ring seine Funktion als Flusskonzentrator: Das externe Magnetfeld wird gechoppert.

Die Fig. 6 zeigt in der Aufsicht einen Ausschnitt eines Magnetfeldsensors, bei dem die Erregerspule in der Form einer Flachspule 32 augebildet ist. Die Flachspule 32 belegt einen Teil des Platzes unterhalb des ringförmigen ferromagnetischen Kerns 4. Da die von der Flachspule 32 erzeugten magnetischen Feldlinien nicht innerhalb des ferromagnetischen Kerns 4 geschlossen werden können, entstehen Störfelder. Die Abmessungen der Flachspule 32 sollten daher klein sein im Vergleich zum Durchmesser D des ferromagnetischen Kerns 4 und die Flachspule 32 sollte möglichst weit von den Auslesesensoren 5, 6 (bzw. Hallelementen 17 - 20) entfernt sein. Die Flachspule 32 besteht aus zwei gegensinnig gewickelten Teilspulen, wovon die eine Teilspule im wesentlichen innerhalb des ferromagnetischen Kerns 4, die andere Teilspule ausserhalb des ferromagnetischen Kerns 4 angeordnet ist. Die Teilspulen sind, wie in der Fig. 6 dargestellt, so gewickelt, dass der Strom, der durch die nahe beim ferromagnetischen Kern 4 verlaufenden Windungsteile fliesst, in die gleiche Richtung fliesst. Anstelle einer einzigen Flachspule können auch mehrere Flachspulen entlang dem ferromagnetischen Kern 4 angeordnet werden.

Bei den heutigen CMOS Prozessen sind mehrere Metallebenen üblich. Diese Metallebenen lassen sich für die Realisierung der Flachspulen benützen, soweit sie nicht für die elektronische Schaltung 7 erforderlich sind.

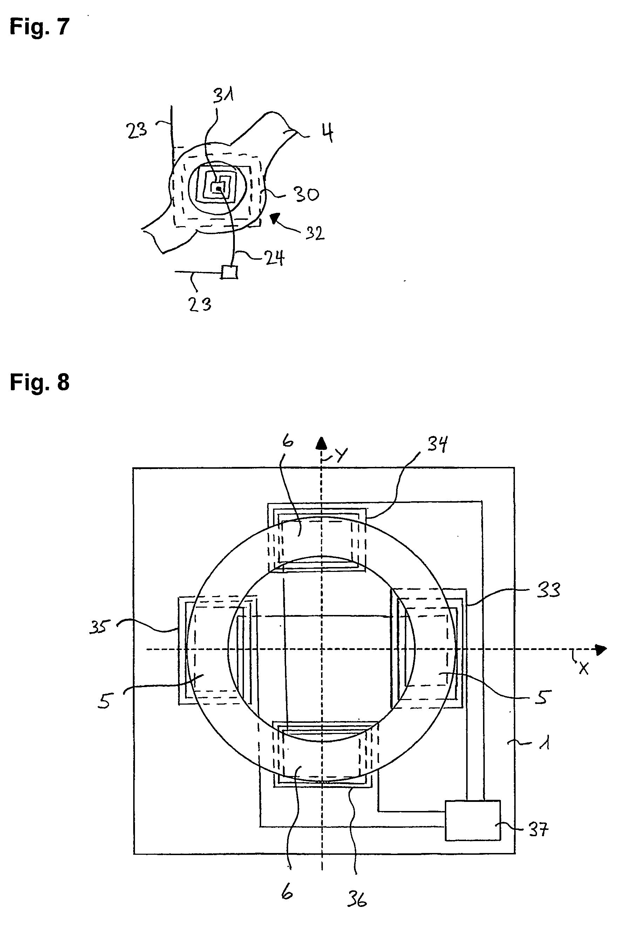

Die Vorschläge gemäss den Figuren 5 und 6 lassen sich kombinieren. In der Fig. 7 ist ein nur einen der kleinen Ringe 30 umfassender Ausschnitt des Magnetfeldsensors gemäss Fig. 5 gezeigt. Unterhalb des kleinen Ringes 30 ist eine Flachspule 32 angeordnet, deren Windungen das Bondpad 31 spiralförmig umkreisen. Die Erregerspule umfasst bei dieser Lösung die Flachspule 32 und die aus der Leiterbahn 23 und aus dem Bonddraht 24 gebildeten Windungen.

Wenn eine möglichst starke Miniaturisierung des Magnetfeldsensors angezielt wird, dann ist die Ausbildung der Auslesesensoren 5, 6 als Hallelemente die richtige Wahl. Wenn andererseits eine möglichst hohe Empfindlichkeit angezielt wird, damit auch extrem kleine Magnetfelder gemessen werden können, dann ist es einerseits erforderlich, den Durchmesser D des ringförmigen ferromagnetischen Kerns 4 relativ gross zu machen, und andererseits sinnvoll, als Auslesesensoren 5, 6 Flachspulen vorzusehen. Die Empfindlichkeit der Flachspulen nimmt nämlich quadratisch mit dem zur Verfügung stehenden Platz und damit quadratisch mit dem Durchmesser D zu, während die Empfindlichkeit der Hallelemente unabhängig von ihrer Grösse ist und damit nur linear mit dem Durchmesser D zunimmt. Bei allen gezeigten Ausführungsbeispielen können daher die Hallelemente durch Flachspulen ersetzt werden. Beispielhaft zeigt die Fig. 8 in der Aufsicht einen Magnetfeldsensor mit Flachspulen 33 bis 36, die als Auslesesensoren 5,6 dienen. Der Klarheit wegen ist die Erregerspule nicht gezeichnet. Die Flachspulen 33 bis 36 sind so gewickelt, dass ihre Windungen das Magnetfeld umschliessen, das wie in der Fig. 2B gezeigt ist, senkrecht zu ihrer Oberfläche verläuft. Die Flachspulen 33 bis 36 sind bevorzugt rechteckförmig oder in ihrer Form der Krümmung des Ringes angepasst, damit ihre Windungen einen möglichst grossen Abschnitt des ferromagnetischen Kerns 4 und damit einen möglichst grossen Anteil des magnetischen Flusses umschliessen. Der Auslesesensor 5 umfasst die beiden Flachspulen 33 und 35, die gegensinnig gewickelt sind, so dass sich ihre Nutzsignale addieren. Der Auslesesensor 6 umfasst die beiden Flachspulen 34 und 36. Die Flachspulen 33 bis 36 sind mit einem Auswerteschaltkreis 37 verbunden. Ein solcher Magnetfeldsensor wird auch als Fluxgate Sensor bezeichnet.

Bei den bisherigen Ausführungsbeispielen wurden horizontale Hallelemente verwendet. Es können aber auch vertikale Hallelemente verwendet werden. Diese sind aber nicht unterhalb des ferromagnetischen Ringes, sondern ausserhalb des ferromagnetischen Ringes im Bereich dessen äusseren Randes anzuordnen. Beim Beispiel der Fig. 3 ergibt sich die ideale Lage der vertikalen Hallelemente durch Spiegelung der Lage der horizontalen Hallelemente 17-20 am äusseren Rand des ferromagnetischen Kerns 4. Vertikale Hallelemente sind nämlich empfindlich auf ein Magnetfeld, das parallel zu ihrer Oberfläche verläuft. Der Verlauf der zu messenden Feldlinien ist aus der Fig. 2B ersichtlich. Die ideale Lage des vertikalen Hallelementes befindet sich daher neben dem äusseren Rand des ferromagnetischen Kerns 4.

## Patentansprüche

1. Magnetfeldsensor für die Messung von wenigstens zwei Komponenten eines Magnetfeldes, mit einem auf einer Oberfläche eines Halbleiterchips (1) aufgebrachten ringförmigen ferromagnetischen Kern (4), einer Erregerspule (2), einer Stromquelle zum Beaufschlagen der Erregerspule (2) mit einem Wechselstrom und mit einem ersten Auslesesensor (5) für die Messung der ersten Komponente des Magnetfelds und einem zweiten Auslesesensor (6) für die Messung der zweiten Komponente des Magnetfelds, wobei die Erregerspule (2) mindestens eine Windung aufweist, wobei ein Teil der Windung durch eine Leiterbahn (9) auf dem Halbleiterchip (1) gebildet ist und wobei ein anderer Teil der Windung durch Bonddrähte (11) oder Bumps (27) gebildet ist, so dass die mindestens eine Windung den ringförmigen ferromagnetischen Kern (4) umschliesst, **dadurch gekennzeichnet, dass** jeder der Auslesesensoren (5, 6) zwei Sensoren umfasst, die auf ein Magnetfeld empfindlich sind, das senkrecht zur besagten Oberfläche des Halbleiterchips (1) verläuft, wobei die beiden Sensoren im Bereich des äusseren Randes des ringförmigen ferromagnetischen Kerns (4) und unterhalb des ferromagnetischen Kerns (4) angeordnet sind.

2. Magnetfeldsensor nach Anspruch 1, **dadurch gekennzeichnet, dass** der ferromagnetische Kern (4) mindestens ein Loch (29) aufweist, dass mindestens eine Wicklung der Erregerspule (2) durch dieses Loch (29) führt, so dass der durch die Erregerspule (2) fliessende Strom den ferromagnetischen Kern (4) im Bereich des mindestens einen Lochs (29) magnetisch in Sättigung bringen kann, ohne dass die übrigen Bereiche des ferromagnetischen Kerns (4) magnetisch gesättigt sind.

3. Magnetfeldsensor nach Anspruch 1 oder 2, **dadurch gekennzeichnet, dass** die Sensoren horizontale Hallelemente (17, 19; 18, 20) sind und dass die beiden Sensoren eines Auslesesensors (5, 6) an einander diametral gegenüberliegenden Seiten des ringförmigen ferromagnetischen Kerns (4) unterhalb des ferromagnetischen Kerns angeordnet sind.

4. Magnetfeldsensor nach einem der Ansprüche 1 bis 3, **dadurch gekennzeichnet, dass** die Dicke des ferromagnetischen Kerns (4) mindestens das 0.5 fache seiner Breite beträgt.

5. Magnetfeldsensor für die Messung von wenigstens zwei Komponenten eines Magnetfeldes, mit einem auf einem Halbleiterchip (1) aufgebrachten ringförmigen ferromagnetischen Kern (4), einer Erregerspule (2), einer Stromquelle zum Beaufschlagen der Erregerspule (2) mit einem Wechselstrom und mit einem ersten Auslesesensor (5) für die Messung der ersten Komponente des Magnetfelds und einem zweiten Auslesesensor (6) für die Messung der zweiten Komponente des Magnetfelds, wobei die Erregerspule (2) mindestens eine Windung aufweist, wobei ein Teil der Windung durch eine Leiterbahn (9) auf dem Halbleiterchip (1) gebildet ist und wobei ein anderer Teil der Windung durch Bonddrähte (11) oder Bumps (27) gebildet ist, so dass die mindestens eine Windung den ringförmigen ferromagnetischen Kern (4) umschliesst, wobei die wenigstens zwei Komponenten des Magnetfelds in der durch den ferromagnetischen Kern (4) aufgespannten Ebene liegen, **dadurch gekennzeichnet, dass** jeder der Auslesesensoren (5, 6) zwei vertikale Hallelemente umfasst, die an gegenüberliegenden Seiten des ferromagnetischen Kerns (4) neben dem äusseren Rand des ferromagnetischen Kerns (4) im Halbleiterchip (1) angeordnet sind.

**Claims**

1. Magnetic field sensor for measuring at least two components of a magnetic field, having a ringshaped ferromagnetic core (4) mounted on a surface of a semiconductor chip (1), an exciter coil (2), a current source for applying an AC current to the exciter coil (2), and a first read-out sensor (5) for measuring the first component of the magnetic field and a second read-out sensor (6) for measuring the second component of the magnetic field, the exciter coil (2) having at least one winding, a part of the winding formed by a conductor track (9) on the semiconductor chip (1) and another part of the winding formed by bonding wires (11) or bumps (27), so that the at least one winding encloses the ferromagnetic core (4), **characterized in that** each read-out sensor (5, 6) comprises two sensors that are sensitive to a magnetic field running perpendicularly to said surface of the semiconductor chip (1), the two sensors located close to the outer edge of the ferromagnetic core (4) and below the ferromagnetic core (4).

2. Magnetic field sensor according to claim 1, **characterized in that** the ferromagnetic core (4) has at least one hole (29), **in that** at least one winding of the exciter coil (2) leads through this hole (29) so that the current flowing through the exciter coil (2) can magnetically saturate the ferromagnetic core (4) in the area of the at least one hole (29) without saturating the remaining areas of the ferromagnetic core (4).

3. Magnetic field sensor according to claim 1 or 2, **characterized in that** the sensors are horizontal Hall elements (17, 19; 18, 20) that the two sensors of a read-out sensor (5, 6) are arranged diametrically to one another on opposite sides of the ferromagnetic core (4) underneath the ferromagnetic core (4).

4. Magnetic field sensor according to any of claims 1 to 3, **characterized in that** the thickness of the ferromagnetic core (4) amounts to at least 0.5 times its width.

5. Magnetic field sensor for measuring at least two components of a magnetic field, having a ringshaped ferromagnetic core (4) mounted on a semiconductor chip (1), an exciter coil (2), a current source for applying an AC current to the exciter coil (2), and a first read-out sensor (5) for measuring the first component of the magnetic field and a second read-out sensor (6) for measuring the second component of the magnetic field, the exciter coil (2) having at least one winding, a part of the winding formed by a conductor track (9) on the semiconductor chip (1) and another part of the winding formed by bonding wires (11) or bumps (27), so that the at least one winding encloses the ferromagnetic core (4), wherein the at least two components of the magnetic field lie in the plane spanned by the ferromagnetic core (4), **characterized in that** each of the read-out sensors (5, 6) comprises two vertical Hall elements located diametrically to one another on opposite sides of the ferromagnetic core (4) next to the outer edge of the ferromagnetic core (4) in the semiconductor chip (1).

**Revendications**

1. Capteur de champ magnétique pour la mesure d'au moins deux composants d'un champ magnétique, comprenant un noyau ferromagnétique annulaire (4) apposé sur une surface d'une puce à semi-conducteurs (1), une bobine d'excitateur (2), une source de courant pour l'alimentation de la bobine d'excitateur (2) en un courant alternatif et comprenant un premier capteur de lecture de sortie (5) pour la mesure du premier composant du champ magnétique et un second capteur de lecture de sortie (6) pour la mesure du second composant du champ magnétique, dans lequel la bobine d'excitateur (2) présente au moins une spire, dans lequel une partie de la spire est formée par une piste conductrice (9) sur la puce à semi-conducteurs (1) et dans lequel une autre partie de la spire est formée par des fils de liaison (11) ou par des tampons (27) de telle sorte la au moins une spire entoure le noyau ferromagnétique annulaire (4), **caractérisé en ce que** chacun des capteurs de lecture de sortie (5, 6) comporte deux capteurs qui sont sensibles à un champ magnétique, lequel s'étend perpendiculairement à ladite surface de la puce à semi-conducteurs (1), dans lequel les deux capteurs sont agencés dans la zone de la bordure extérieure du noyau ferromagnétique annulaire (4) et en dessous du noyau ferromagnétique (4).

2. Capteur de champ magnétique selon la revendication 1, **caractérisé en ce que** le noyau ferromagnétique (4) présente au moins un trou (29), **en ce qu'**au moins une spire de la bobine d'excitateur (2) mène à travers ce trou (29) de telle sorte que le courant qui passe à travers la bobine d'excitateur (2) peut amener le noyau ferromagnétique (4) à saturation par action magnétique dans la zone du au moins un trou (29), sans que les zones résiduelles du noyau ferromagnétique (4) soient saturées par action magnétique.

3. Capteur de champ magnétique selon la revendication 1 ou 2, **caractérisé en ce que** les capteurs sont des éléments horizontaux à effet de Hall (17, 19; 18, 20) et **en ce que** les deux capteurs d'un capteur de lecture de sortie (5, 6) sont agencés sur des côtés diamétralement opposés l'un à l'autre du noyau ferromagnétique annulaire (4) en dessous du noyau ferromagnétique.

4. Capteur de champ magnétique selon l'une des revendications 1 à 3, **caractérisé en ce que** l'épaisseur du noyau ferromagnétique (4) se monte au moins à 0.5 fois sa largeur.

5. Capteur de champ magnétique pour la mesure d'au moins deux composants d'un champ magnétique, comprenant un noyau ferromagnétique annulaire (4) apposé sur une puce à semi-conducteurs (1), une bobine d'excitateur (2), une source de courant pour l'alimentation de la bobine d'excitateur (2) en un courant alternatif et comprenant un premier capteur de lecture de sortie (5) pour la mesure du premier composant du champ magnétique et un second capteur de lecture de sortie (6) pour la mesure du second composant du champ magnétique, dans lequel la bobine d'excitateur (2) présente au moins une spire, dans lequel une partie de la spire est formée par une piste conductrice (9) sur la puce à semi-conducteurs (1) et dans lequel une autre partie de la spire est formée par des fils de liaison (11) ou par des tampons (27) de telle sorte que la au moins une spire entoure le noyau ferromagnétique annulaire (4), dans lequel les au moins deux composants du champ magnétique sont disposés dans le plan défini par le noyau ferromagnétique (4), **caractérisé en ce que** chacun des capteurs de lecture de sortie (5, 6) comporte deux éléments verticaux à effet de Hall qui sont agencés sur des côtés opposés du noyau ferromagnétiques (4) à côté du bord extérieur du noyau ferromagnétique (4) dans la puce à semi-conducteurs (1).

**Fig. 1**

**Fig. 2A**

**Fig. 2B**

**Fig. 3**

**Fig. 4**

## Fig. 5

## Fig. 6

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 359922 A1
- EP 1052519 A1
- US 4692703 A

**In der Beschreibung aufgeführte Nicht-Patentliteratur**

- **AUTOREN L. CHIESI ; P. KEJIK ; B. JANOSSY ; R.S. POPOVIC.** CMOS planar 2D micro-fluxgate sensor. *Zeitschrift Sensors and Actuators,* 2000, vol. 82, 174-180